# EUROPEAN PATENT SPECIFICATION

(11) **EP 1 573 894 B1**
(45) Date of publication and mention of the grant of the patent: **13.07.2011**
(21) Application number: 03775657.4
(22) Date of filing: 01.12.2003
(51) Int. Cl.: H03B 5/12, H01H 59/00

(54) **DRIVING OF AN ARRAY OF MICRO-ELECTRO-MECHANICAL-SYSTEM (MEMS) ELEMENTS**
ANSTEUERN EINES ARRAYS VON ELEMENTEN EINES MIKROELEKTROMECHANISCHEN SYSTEMS (MEMS)
COMMANDE D'UN RESEAU D'ELEMENTS MEMS (MICROSYSTEMES ELECTROMECANIQUES)

(30) Priority: 10.12.2002 EP 02080219
(43) Date of publication of application: 14.09.2005
(73) Proprietor: EPCOS AG, 81669 München (DE)
(72) Inventor: RIJKS, Theodoor, G., S., M., NL-5656 AA Eindhoven (NL); MATTERS, Marco, NL-5656 AA Eindhoven (NL); VAN BEEK, Jozef, T., M., NL-5656 AA Eindhoven (NL)
(74) Representative: Epping - Hermann - Fischer
(86) International application number: PCT/IB2003/005590
(87) International publication number: WO 2004/054088

(56) References cited:
- EP-A- 1 089 110
- US-A- 4 674 180

## Description

The invention relates to an electronic device comprising an array of micro-electro-mechanical-system (MEMS) elements, said array providing a plurality of states at its output.

The invention also relates to a driving of an array of micro-electromechanical system (MEMS) elements, said array providing a plurality of states at its output.

MEMS (micro-electro-mechanical-systems) technology is used to develop tunable passive components for RF modules in wireless applications. MEMS technology has already been applied in products like sensors and projection displays. Application in RF circuits reduces power consumption and enhances the functionality of wireless communication systems. In particular, MEMS technology is applied in integrated RF front ends.

A possible RF-MEMS component is a variable capacitor with a flexible metal top electrode. By applying a DC voltage, this electrode moves downwards, leading to a capacitance increase with voltage, until it snaps down. The voltage at which this occurs is called Vclose. The capacitor can be used as a tunable capacitor (V<Vclose) or as a switchable capacitor (V>Vclose). The latter can also be used as an RF switch. MEMS components can be made by surface micro machining, and IC-compatible thin-film technology. For building the movable part, a sacrificial layer is used, which can be selectively removed underneath the structural layer, thereby creating a freestanding structure.

The MEMS technology can yield small, low-weight tunable/switchable RF components, which out-perform semiconductor switches and varicaps in power consumption, linearity and insertion losses. The technology allows integration with other active/passive components for tunable RF modules, offering improved functionality and compactness. With tunable/switchable components in RF front ends, new re-configurable RF transceiver architectures can be designed for present and next-generation wireless communication systems. An example for this is an adaptive impedance matching network. To drive an adaptive impedance network which is made of an array of N MEMS elements, through N control voltages requires a lot of interconnect and driving electronics (high voltage transistors).

The WO 99/43013 relates to a micro-mechanical electrostatic relay comprising at least one base substrate with a flat base electrode, as well as a rotor blade which is stemmed from the rotor substrate and as a flat rotor electrode, wherein a wedge-shaped air gap is formed between the base substrate and said rotor blade. An electrode layer is further formed on at least one of the surfaces defining the air gap so as to obtain a switching characteristic providing for closing, opening or change over. There are control lines for every single relay and there are further lines to control a few relays in parallel.

US 5 880 921 discloses a monolithically integrated switched capacitor bank using MEMS technology that is capable of handling GHz signal frequencies in both the RF and millimeter bands while maintaining precise digital selection of capacitor levels over a wide tuning range. Each MEMS switch includes a cantilever arm that is affixed to the substrate and extends over a ground line and a gapped signal line. An electrical contact is formed on the bottom of the cantilever arm positioned above and facing the gap in the signal line. A top electrode at the top of the cantilever arm forms a control capacitor structure above the ground line. A capacitor structure, preferably a MEMS capacitor suspended from the substrate at approximately the same height as the cantilever arm, is anchored to the substrate and connected in series with a MEMS switch. The MEMS switch is actuated by applying a voltage to the top electrode, which produces an electrostatic force that attracts the control capacitor structure toward the ground line, thereby causing the electrical contact to close the gap in the signal line and connect the MEMS capacitor structure between a pair of output terminals. The integrated MEMS switch-capacitor pairs have a large range between their on-state and off-state impedance, and thus exhibit superior isolation and insertion loss characteristics.

In US 5 872 489, an integrated, tunable inductance network features a number of fixed inductors fabricated on a common substrate along with a switching network made up of a number of micro-electromechanical (MEM) switches. The switches selectably interconnect the inductors to form an inductance network having a particular inductance value, which can be set with a high degree of precision when the inductors are configured appropriately. The preferred MEM switches introduce a very small amount of resistance, and the inductance network can thus have a high Q. The MEM switches and inductors can be integrated using common processing steps, reducing parasitic capacitance problems associated with wire bonds and prior art switches, increasing reliability, and reducing the space, weight and power requirements of prior art designs. The precisely tunable high-Q inductance network has wide applicability, such as in a resonant circuit which provides a narrow bandwidth frequency response which peaks at a specific predetermined frequency, making a highly selective performance low noise amplifier (LNA) possible, or in an oscillator circuit so that a precise frequency of oscillation can be generated and changed as needed.

Document US4674180 discloses a device according to the preamble of claim 1.

It is an object of the invention to provide a method for driving an array of MEMS elements and a device comprising such array of the kind mentioned in the opening paragraphs, whereby the interconnect and driving electronics may be substantially reduced.

This object is achieved in the device of claim 1.

The object with respect to the driving method is achieved in that a single control voltage is applied to all the MEMS elements in the array of the invention, which voltage is varied to obtain the various states of the array.

The RF-MEMS elements in the device according to the invention show differences in the required switching voltage. By tuning the on-state and off-state switching voltages of all RF MEMS components in an array, all available states of the array can be assessed by sweeping one single control voltage according to a predefined scheme. It is thus not necessary for the array to comprise rows and columns at the crossing of which a MEMS element and a transistor are provided.

The important advantage of the device of the invention is particularly that the number of transistors can be substantially reduced. This advantage must be considered important, since any conventional transistor is manufactured on a different scale and in a different technology than the MEMS devices. For RF applications it is advantageous to provide the MEMS elements with other passive components on a single substrate, which substrate preferably has a high resistivity. However, for a transistor a substrate with a low resistivity is required. The reduction of the number of transistors is also advantageous if discrete transistors are to be applied, since such driving transistors need to be able to provide reasonably high voltages, for instance about 30 V, and such transistors are expensive.

The states in the array may be used to advantage for various purposes. The states can be memory states, logical states or displaying states for instance. A first application is in the RF domain where the MEMS elements can be applied as switches between various telecommunication bands, and the transmission or reception of signals thereon. Another application is the use of the MEMS elements as discretely tunable capacitors. A further application is the use of the MEMS elements with inductors, such that the inductance can be set.

In a preferred embodiment the array comprises a first and a second MEMS element that each have a characteristic hysteresis curve, such that the opening voltage is different from the closing voltage, and that the opening voltage and control voltage of the first MEMS element are different from those of the second MEMS element. In this manner the number of states is enlarged considerably. The embodiment is for instance produced with MEMS capacitors, of which the opening and closing voltages can be easily made to differ enough so as to produce the hysteresis behavior. Of course it may be that there is a further MEMS element in the array of which the closing and opening voltages do not or not substantially differ.

It is particularly preferred that the characteristic hysteresis curves have different widths in an operational diagram of capacitance versus control voltage. This means that not only the opening voltage of a first MEMS element is different from that of a second MEMS element in the same array, but also that the voltage gap between opening and closing voltage is different for the first and the second MEMS element. In this manner, the hysteresis curve of a first MEMS element may lie fully within the hysteresis curve of the second MEMS element.

In an advantageous further embodiment, which increases the ease of driving the array, the characteristic hysteresis curves of the MEMS elements are centered about a common centerline in the operational diagram. This feature allows building up an array of MEMS elements to store logical states, wherein the distance between every logical state is equal to another distance.

According to a preferred embodiment of the invention, MEMS elements of the electrostatic type with a suspended, movable electrode are present. This means that each of the MEMS elements in the array has a fixed electrode and a movable electrode that is movable towards and from the fixed electrode by application of the closing and the opening voltage respectively, such that in the first state the distance between the fixed and the movable electrode is smaller than in the second state. The movable electrode herein is suspended substantially parallel to the fixed electrode and anchored to a support structure by at least one cantilever arm having a spring constant, and the MEMS element is provided with an actuation electrode with an actuation area for provision of the closing and opening voltages. The MEMS elements may be switches, but alternatively tunable capacitors. In view of their robustness, tunable capacitors are preferred.

In a further embodiment hereof, a first and a second MEMS element in the array have different characteristic hysteresis curves in that at least one of the actuation areas of the control electrodes are different and/or the spring constants of the cantilever arms are different. In this manner the different characteristic curves are set with mechanical means. It is possible to tune the hysteresis curve of the MEMS elements by mechanical properties. The spring force that has to be matched by the electrostatic force increases with increasing displacement. Each element can have a different spacer height or different number/placement of spacers. This can be used to tune the voltage where the hysteresis curve goes up, called Vopen, leaving the voltage where the hysteresis curve goes down, called Vclose, unaffected. The tuning of Vclose and Vopen varies by the same factor √(k/A). The parameter k means the tuning spring constant and the parameter A means the actuation area.

In another further embodiment, at least one dielectric layer having a dielectric permittivity is present between the fixed and the movable electrode, such that the MEMS element is a MEMS capacitor, of which capacitor the first state has a first state capacitance. Furthermore, a first and a second MEMS capacitor in the array have different characteristic hysteresis curves in that the first state capacitances of the first and the second MEMS capacitor are different. In this manner the different characteristic curves are set with chemical means.

Examples of such chemical means of influencing the first state capacitances include the adaptation of the capacitor area; the extent to which the dielectric layer covers the fixed electrode - e.g. completely or only partially; the thickness of the dielectric layer and the thickness of a spacer between fixed and movable electrode that determines the air gap; the variation of the dielectric permittivity of the dielectric layer; and the provision of a second optionally patterned layer on top of the dielectric layer.

The provision of the second layer that is patterned differently in different MEMS elements is particularly preferred, since it can be realized with a minimum of additional process steps. Further, it can be very suitably combined in a process on wafer level, in which not only MEMS elements, but also integrated passives are manufactured to obtain a passive circuit.

For the variation of the dielectric permittivity, several options are open. A first option is the provision of a number of patterned dielectric materials with different dielectric permittivity. Examples of suitable materials are silicon nitride and silicon oxide. Another option is the provision of electrical charge in the dielectric layer by carrying out an implantation step, wherein the implantation dosis is varied from one MEMS element to another. An advantage of this is that substantial differences in closing and opening voltages can be realized. Due to the implantation, the behavior of capacity as a function of voltage is shifted as a whole. The implantation step is not too complicated practically, since it is done anyway to provide a desired doping level in the substrate, for instance for the definition of CMOS transistors, if present.

Instead of variation of the dielectric permittivity the effective electric field can be varied. This is for instance done by applying a layer of ferro-electric material on top of the dielectric layer. As a result, both the opening and the closing voltage as well as the hysteresis behavior will be changed.

As a skilled person will understand, it is highly preferred to use more than one means in order to realize the desired different opening and closing voltages. Especially, both mechanical and chemical means are used. In this manner, the number of different opening voltages in the array may be increased to up to about 10, preferably in the range from 3-7. Nevertheless, all opening and closing voltages are sufficiently different to be able to open one MEMS element specifically. Also, the number of additional processing steps is limited, e.g. preferably less than five with only one additional photolithographical step.

It is further preferred that the MEMS elements in the array are connected in parallel. This allows that all MEMS elements are driven directly. The input for a single control voltage is preferably a transistor. Such a transistor may be a discrete transistor. However, it may also be integrated with a driving circuit.

In a further embodiment, the device comprises a plurality of arrays of MEMS elements, each array having an input for a single control voltage.

Furthermore, the device may be or include an impedance matching network with capacitors and MEMS elements as tunable capacitors. Such tunable impedance matching network is highly preferred in view of the increasing number of communication bands available in mobile communication equipment and in view of the fact that at least some of these bands are very wide. Particularly, such an impedance matching network in which the invention is implemented, has the advantage that one basic component is suitable for various applications. The one basic component can then be set, in line with the application and circumstances, by choosing the required impedance transformations. This choice can be made on the basis of a table of impedance transformations that is delivered with the device. In comparison with alternative implementations, the invention allows to use minimal tunable capacitors.

A further application of the combination of MEMS elements and capacitors and inductors is for instance an adaptive LC-circuit for a voltage-controlled oscillator.

These and various other advantages and features of novelty which characterize the present invention are pointed out with particularity in the claims annexed hereto and forming part hereof. However, for a better understanding of the invention, its advantages, and the objective obtained by its use, reference should be made to the drawings which form a further part hereof, and to the accompanying descriptive matter in which there are illustrated and described preferred embodiments of the present invention.
Figure 1 shows the measured capacitance of a MEMS capacitor as a function of the control voltage;
Figure 2 shows the subsequent switching scheme of the MEMS capacitors in a 3-capacitor array;
Figure 3 shows an example of using the memory effect in the switching of an array of two MEMS capacitors;
Figure 4 shows an example of using the memory effect in the switching of an array of three MEMS capacitors;
Figure 5 shows the difference of the hysteresis of the MEMS elements by tuning the Vclose and Vopen up by increasing the spring constant k;
Figure 6 shows the effect of subsequent charge implantation on the elements shown in Figure 5;
Figure 7 shows a practical embodiment of the tuning of the hysteresis of the first capacitance of an array of three capacitances;
Figure 8 shows a practical embodiment of the tuning of the hysteresis of the second capacitor of an array of three capacitors;
Figure 9 shows the tuning of the hysteresis by charge implantation of a third capacitance of an array of three capacitances;
Figure 10 shows an example of a MEMS switch;
Figure 11 shows a cross-sectional view of a switch along the line A'-A" in Figure 12; and
Figure 12 shows a top view of a switch and a line A'-A" along which line the cross-sectional view of Figure 11 is shown.

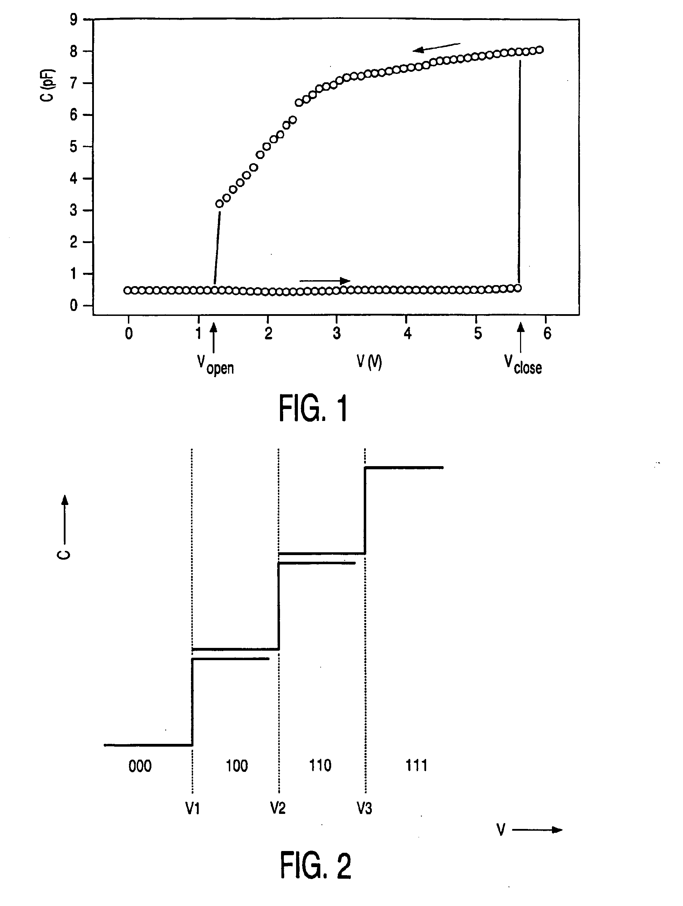

Figure 1 shows the measured capacitance of a MEMS capacitor as a function of the control voltage. When the control voltage is increased to Vclose, the top electrode of the capacitor collapses, closing the air gap between the electrodes, and the capacitance goes up. When, subsequently, the DC voltage is decreased, the capacitor opens again at Vopen and the capacitance goes down again. Each MEMS element exhibits hysteresis in the switching voltage, i.e., the voltage required to close the air gap (Vclose) is different from the voltage required to open it again (Vopen). By using this memory effect in an array ofN MEMS elements, all 2^{N} states of an array of N MEMS switches can be assessed with only one control voltage.

Figure 2 shows a capacitance-voltage diagram which shows steps from V 1 to V2 to V3. A logical state is assigned to every step. The example shows four states which can be represented by an array of three MEMS elements. In general it may be said that in an array ofN switches each switch can be driven independently when N control voltages are used. This yields 2^{N} different states but requires a lot of interconnect and driving electronics. Exactly this enormous effort of interconnect and driving electronics is reduced by the present invention. In this example, the application of only one control voltage switching the states of the array by tuning of the switching voltage of each switch through its mechanical properties, without taking advantage of the hysteresis of the switches, provides that the switches will subsequently close during a voltage sweep, however yielding only N+1 different states.

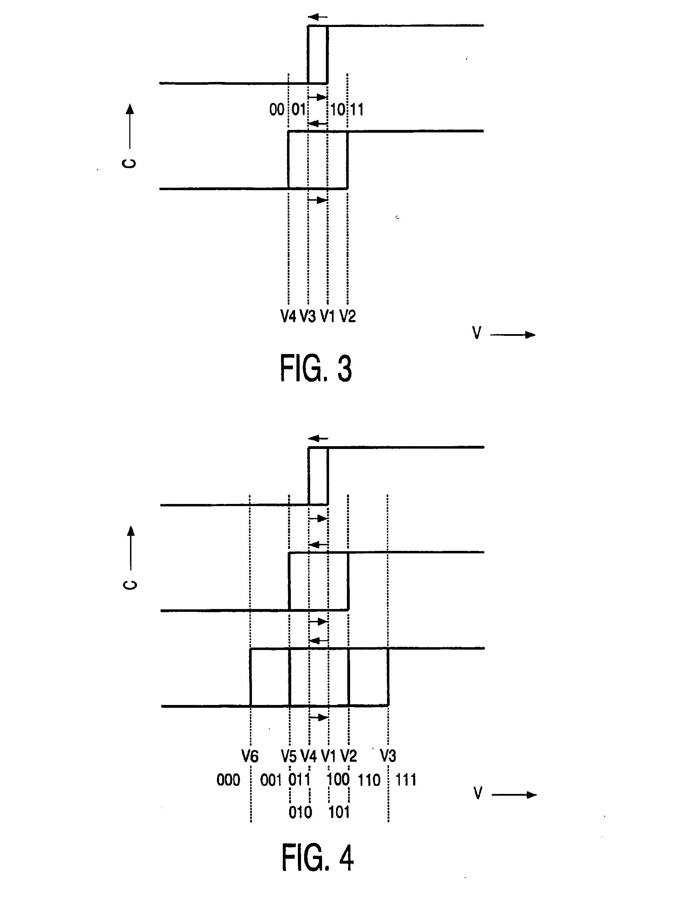

Figure 3 shows an example of the switching of an array containing two capacitors by tuning Vclose and Vopen for each capacitor to appropriate (different) values. Four distinct states are available in this array. As use is made of a memory effect, not only the value of the control voltage, but also the form of the preceding voltage sweep determines the state of the MEMS array. For example, to reach the 01 state, the control voltage has to be swept from V4 to V2 to V3. At a voltage of 0 and V2 the array is reset. So starting from a reset point each state can be activated with a predefined voltage sweep.

Figure 4 shows an array of three MEMS elements which can represent eight different states according to the same principles shown above in connection with Figure 3. As mentioned above, the memory effect is responsible that not only the value of the control voltage is necessary to achieve one state but also the form of the preceding voltage sweep determines the reachable state of the MEMS array. For example to reach the 010 state, the control voltage has to be swept from V6 to V2 to V4.

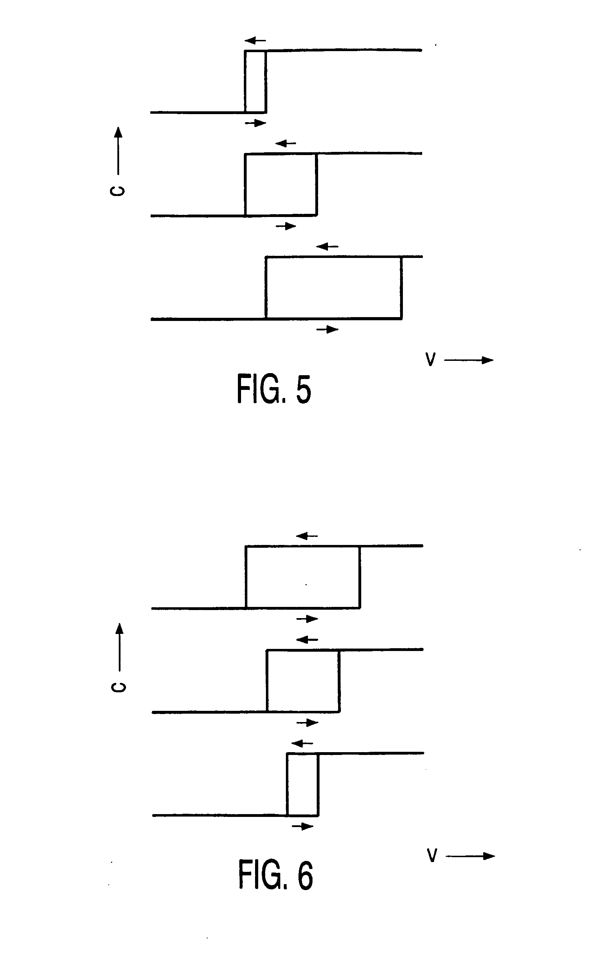

Figure 5 shows a first practical embodiment of the invention. Figure 5 shows three different hysteresis curves with different widths. In this embodiment, the voltages Vopen and Vclose (hysteresis) are tuned by the spring constant k. Therefore, the reason for the three different hysteresis widths in Figure 5 is the fact that there are three different spring constants k. As a second step, the hysteresis curves have to be off-set as described with reference to Figure 6.

Figure 6 shows three different capacitance-voltage curves of individual MEMS components, which have a different amount of hysteresis and are centered with respect to each other. In order to offset the capacitance-voltage curves an appropriate amount of charge implantation is used. The charge implantation C 1 and C3 has the same polarity. Table 1 shows the individual values of Vopen and Vclose of each capacitor after each step.

**Tab. 1: Voltage values of three MEMS capacitors after tuning of Vopen and Vclose (step 1) and offsetting of the hysteresis curves (step 2).**

| | **Initial** | | **After step 1 (****Fig. 5****)** | | **After step 2 (****Fig. 6****)** | |
|---|---|---|---|---|---|---|
| | **Vopen (V)** | **Vclose (V)** | **Vopen (V)** | **Vclose (V)** | **Vopen (V)** | **Vclose (V)** |
| **C1** | 1 | 6 | 1 | 6 | 2.45 | 35 |
| **C2** | 1 | 6 | 5 | 30 | 5 | 30 |
| **C3** | 1 | 6 | 10 | 60 | 8.25 | 25 |

The tuning of Vclose and Vopen can be realized by six different methods.
Method 1 uses the tuning of the spring constant k and the actuation area A. Vclose as well as Vopen varies by the same factor √(k/A), so Vclose will have a large absolute tuning range, considerably larger than for Vopen. A similar effect can be achieved by using fixed capacitors in series with the MEMS capacitors, i.e. a capacitive voltage divider. The effective voltage on the MEMS capacitor is then (Cmems/(Cmems+Cfixed))*Vcontrol.
Method 2 varies the effective dielectric permittivity ε*_{eff}* of the dielectric layer. The electrostatic force on the top electrode in the closed state increases with increasing ε*_{ff}*, for a given control voltage. Therefore, Vopen can be tuned by a factor of √(1/ε*_{eff}*). Vclose is also affected by this to a certain extent. Also possible is the application of a closed layer in a first capacitor, a patterned layer in a second capacitor and no dielectric layer in a third capacitor. Besides, variation of the thickness of the dielectric layer as well as the air gap between individual capacitors is also possible.
Method 3 discloses the variation of the displacement of the top electrode in its closed state by using (isolating) spacers. The spring force that has to be matched by the electrostatic force increases with increasing displacement. Each capacitor can have a different spacer height or different number/placement of spacers. This can be used to tune Vopen leaving Vclose unaffected.
Method 4 replaces the dielectric layer by an electrical charge containing a (dielectric) layer. This can be realized by implantation of ions in an isolator (i.e. SiO₂). The fixed electrical charge will offset both Vopen and Vclose. According to V = Q/C, the offset of Vclose will be larger than for Vopen. When using a monovalent ion for implantation on a 1pF 0.1mm² capacitor, a dose of the order of 10¹⁰ ions/cm² is required for a voltage offset of 1V. The voltage offset of the individual components can be varied by structuring the charged layer or performing selective implantation using a shadow mask. Whether the offset increases or decreases the actuation voltage is determined by the polarity of the implantation, the position of the implantation (close to top of bottom electrode), and the polarity of the external voltage.
Method 5 uses ferro-electric materials to manipulate the hysteresis.
Method 6 uses different spring constants for the anchor of a MEMS capacitor. This causes a "role-off'-like opening of the capacitor that influences Vopen. By varying the difference of the spring constants between the individual components, Vopen can be varied.

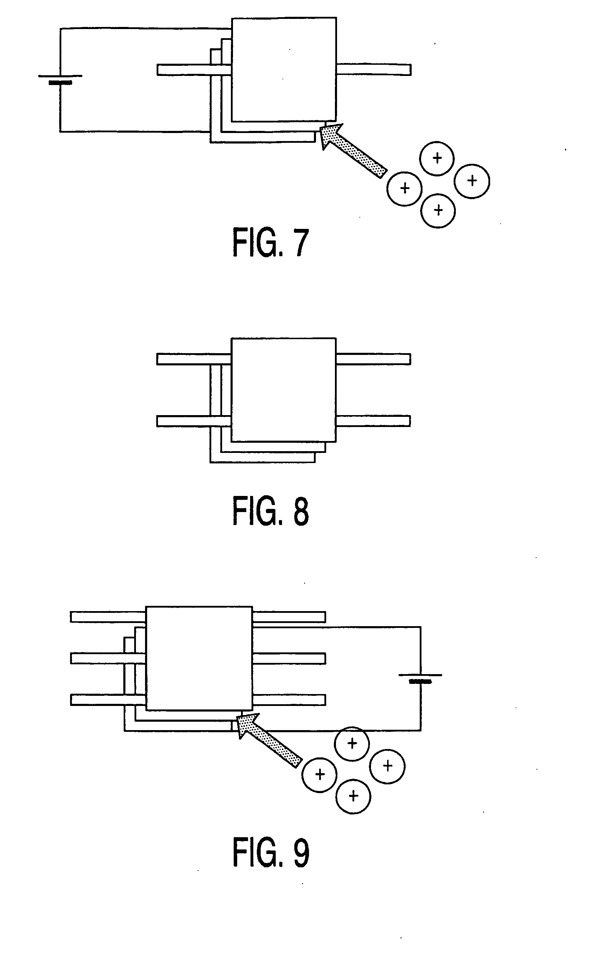

Figures 7, 8, and 9 show the physical embodiments of tuning the hysteresis curves shown in Figures 5 and 6, in terms of capacitors with a different number of spring elements or hinges in order to vary the spring constant. In other words, the tuning comprises a combination of different spring constants by a different number of spring elements or hinges and charge implantation in the dielectric. The spring constants are tuned as described in Figure 5 and Figure 6. The offsetting of the capacitance-voltage curves using an appropriate amount of charge implantation is shown in Figure 7 and Figure 9. The charge implantation in C1 and C3 has the same polarity. The actuation voltages are increased and decreased, respectively, by using a different polarity of the externally applied voltage (a DC voltage). The externally applied voltage in Figure 7 is different from that in Figure 9.

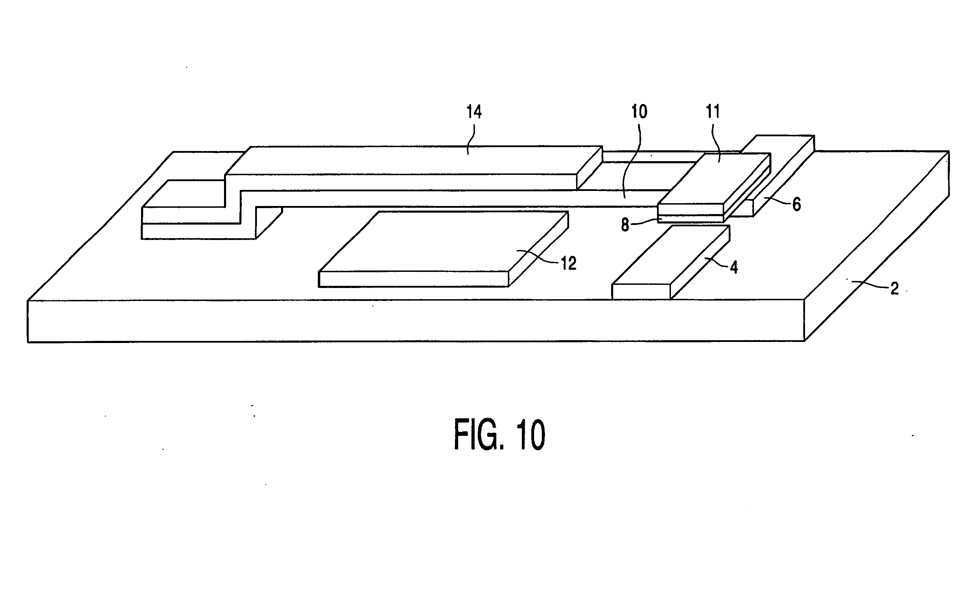

Figure 10 shows an example of a MEMS switch. The switch is created on a non-conducting substrate 2. Conducting bottom electrodes 4, 6 are mounted on top of a substrate 2. A beam 10, 11 made of non-conducting substrate is mounted on the substrate 2. The electrostatic force which pulls the beam 10,11 down, is created between the bottom electrode of an actuation capacitor 12 which is mounted on the non-conducting substrate 2 and the top electrode of an actuation capacitor 14 which is mounted on the beam 10. If the electrostatic force is strong enough between the capacitors 12 and 14 the beam 10, 11 is pulled down and a contact between 8 and 4 and 8 and 6 is established. If the electrostatic force between 14 and 12 decreases, the force of the spring constant of the beam increases and therefore the switch opens the contact between the part 8 and 4 and the part 8 and 6.

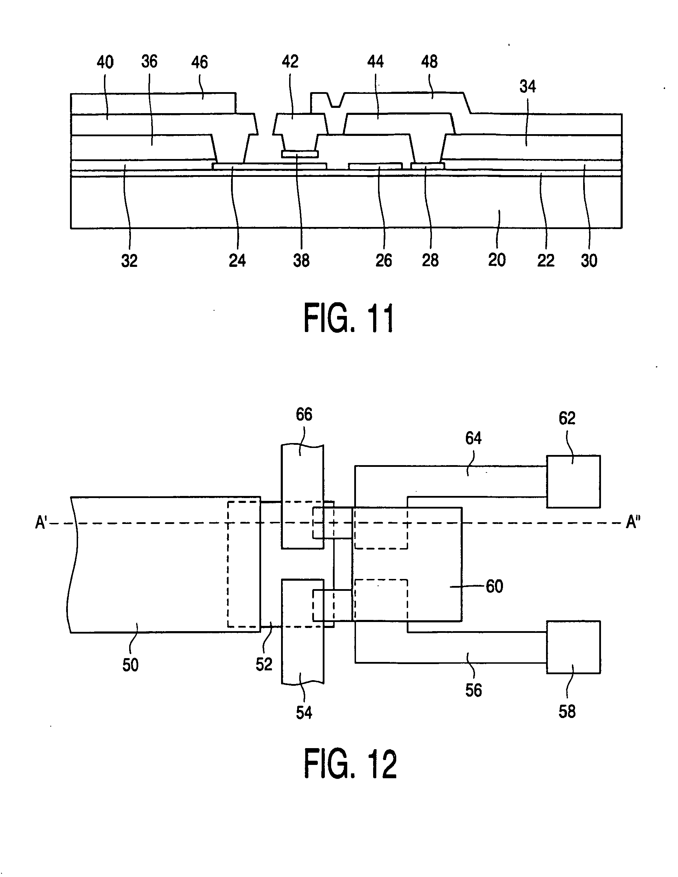

Figure 11 shows a cross-sectional view of a MEMS switch. A carrier 20 is created at the beginning of a process of the switch. On top of the carrier 20 is a passivation layer 22. On top of the passivation layer 22 are a dielectric layer 30, 32 and the first metal layer 24, 26, 28. A sacrificial layer 34, 36 is mounted on top of the dielectric layer 30, 32. A third metal layer 40 is mounted on top of the first metal layer 24 and a third metal layer 44 is mounted on top of the first metal layer 28. An insulator (PI) 46 is mounted on top of the third metal layer 40. An insulator (PI) 48 is mounted on top of the sacrificial layer 34, the third metal layer 44 and partly on top of the third metal layer 42. The second metal layer 38 is attached to the bottom of the third metal layer 42. The electrostatic force is created between the first metal layer 26 and the third metal layer 44. If the electrostatic force pulls down the anchor comprising the parts 38, 42, 44, and 48 then the electrical contact is established between the parts 24 and 38. In the case of decrease of the electrostatic force then the said anchor goes up and opens the electrical contact. The cross-sectional view of the switch shown in Figure 11 corresponds to the line A'-A".

Figure 12 shows the top view of a MEMS switch. The view shows that each switch actually comprises two individual switches named A, and named B. The Figure 12 shows the common input 50 which corresponds to the part with the number 40 in Figure 11. The common input 50 corresponds to the third metal layer 40 in Figure 11. The first metal layer 52 corresponds to the first metal layer 24 of Figure 11. The output 66 of switch A corresponds to the third metal layer 42 of Figure 11. The output of switch B corresponds to the part numbered 54. The output 54 of switch B is also a third metal layer. The first metal layer 26 of Figure 11 corresponds to the first metal layer 64 in Figure 12. The part 56 is also a first metal layer. The ground 60 of Figure 12 is a third metal layer and corresponds to the number 44 of Figure 11. The part numbered 62 is the DC drive of switch A and the part numbered 58 is the DC drive of switch B.

For each switch the electrostatic drive is between the first metal layer corresponding to 24, 26, 28 and the third metal layer corresponding to 40, 42, and 44. In the "normal" configuration the switch is in the so-called open position, i.e., no contact is established. When a voltage is applied, the electrostatic force between the first metal layer corresponding to 24, 26, and 28 and the third metal layer corresponding to 40, 42, and 44 pulls the third metal layer down. Attached to the third metal layer 44, yet, isolated by the passivation layer which is an insulator (PI) 48 is a second section also made in the third metal layer 42. This could be a coil. The third metal layer section 42 is extended by the second metal layer 38 in order to be closer to the first metal layer 24 when the contact is to be established. That is, contact between the common input 50 of the two switches A and B and drives 62 or 58 or both, is established throughout the third metal layer 42, the second metal layer 38 section and the first metal layer 24.

New characteristics and advantages of the invention covered by this document have been set forth in the foregoing description. It will be understood, however, that this disclosure is, in many respects, only illustrative. Changes may be made in details, particularly in matters of shape, size, and arrangement of parts, without exceeding the scope of the invention. The scope of the invention is, of course, defined in the language in which the appended claims are expressed.

## Claims

1. An electronic device comprising an array of micro-electromechanical System (MEMS) elements, said array providing a plurality of states at its output, wherein
- the MEMS elements each have a first state and a second state,
- a transition from the first to the second state is effected by an opening voltage, and a transition from the second to the first state is effected by a closing voltage, and the array comprises an input for a single control voltage that is applied to all the MEMS elements whereby the various states of the array are to be obtained by varying the single control voltage,
- the MEMS elements each have a characteristic hysteresis curve, such that the opening voltage is different from the closing voltage, which characteristic hysteresis curves and the corresponding opening and closing voltages differ from one MEMS element to another MEMS element, and **characterised by**
- the characteristic hysteresis curves differing from one MEMS element to another MEMS element by their individual width are designed such that the hysteresis curve having a smaller width is located fully within the width of the hysteresis curve having the next-larger width.

2. The device of Claim 1, wherein the MEMS elements in the array are connected in parallel.

3. The device of Claim 1, wherein the number of MEMS elements in the array is in the range from 2 to 10.

4. The device of Claim 1, wherein the input for a single control voltage is a transistor.

5. The device of Claim 1 comprising a plurality of arrays of MEMS elements, each array having an input for a single control voltage.

6. The device of Claim 1, wherein each of the MEMS elements in the array has a fixed electrode and a movable electrode that is movable towards and away from the fixed electrode by application of the closing and the opening voltage respectively, such that in the first state the distance between the fixed and the movable electrode is smaller than in the second state, which movable electrode is suspended substantially parallel to the fixed electrode and anchored to a support structure by at least one cantilever arm having a spring constant, which MEMS element is provided with an actuation electrode with an actuation area for provision of the closing and opening voltages.

7. The device of claim 1, wherein a first and a second MEMS element in the array have different characteristic hysteresis curves in that actuation areas of the control electrodes of the first and second MEMS element are different and/or the spring constants of the cantilever arms are different.

8. The device of claim 6, wherein
- at least one dielectric layer having a dielectric permittivity is present between the fixed and the movable electrode, such that the MEMS element is a MEMS capacitor, of which capacitor the first state has a first state capacitance, and
- a first and a second MEMS capacitor in the array have different characteristic hysteresis curves in that the first state capacitances of the first and the second MEMS capacitor are different.

9. The device of claim 1, wherein the characteristic hysteresis curves of the MEMS elements are centered around a common centerline in the operational diagram.

10. Method for driving an array of micro-electromechanical System (MEMS) elements according to any of the preceding Claims, wherein a single control voltage is applied in common to the MEMS elements in the array, which voltage is varied to obtain the various states of the array.

## Patentansprüche

1. Elektronisches Bauelement, das ein Array von MEMS-Elementen (Micro-Electromechanical System) umfasst, wobei das Array eine Mehrzahl von Zuständen an seinem Ausgang liefert, wobei
- die MEMS-Elemente jeweils einen ersten Zustand und einen zweiten Zustand aufweisen,
- ein Übergang von dem ersten zu dem zweiten Zustand durch eine Öffnungsspannung bewirkt wird und ein Übergang von dem zweiten zu dem ersten Zustand durch eine Schließspannung bewirkt wird und das Array einen Eingang für eine einzelne Steuerspannung umfasst, die an alle die MEMS-Elemente angelegt wird, wodurch die verschiedenen Zustände des Arrays durch Variieren der einzelnen Steuerspannung erhalten werden,
- die MEMS-Elemente jeweils eine charakteristische Hysteresekurve aufweisen, so dass die Öffnungsspannung von der Schließspannung verschieden ist, wobei die charakteristischen Hysteresekurven und die entsprechende Öffnungs- und Schließspannung von einem MEMS-Element zu einem anderen MEMS-Element differieren, und **dadurch gekennzeichnet, dass**
- die charakteristischen Hysteresekurven, die von einem MEMS-Element zu einem anderen MEMS-Element durch ihre individuelle Breite differieren, so ausgelegt sind, dass die Hysteresekurve mit einer kleineren Breite sich ganz innerhalb der Breite der Hysteresekurve mit der nächstgrößeren Breite befindet.

2. Bauelement nach Anspruch 1, wobei die MEMS-Elemente in dem Array parallel geschaltet sind.

3. Bauelement nach Anspruch 1, wobei die Anzahl der MEMS-Elemente in dem Array im Bereich von 2 bis 10 liegt.

4. Bauelement nach Anspruch 1, wobei der Eingang für eine einzelne Steuerspannung ein Transistor ist.

5. Bauelement nach Anspruch 1, umfassend eine Mehrzahl von Arrays von MEMS-Elementen, wobei jedes Array einen Eingang für eine einzelne Steuerspannung aufweist.

6. Bauelement nach Anspruch 1, wobei jedes der MEMS-Elemente in dem Array eine feste Elektrode und eine bewegliche Elektrode aufweist, die durch Anlegen der Schließ- beziehungsweise der Öffnungsspannung zu der festen Elektrode beziehungsweise von dieser weg bewegt werden kann, so dass in dem ersten Zustand der Abstand zwischen der festen und der beweglichen Elektrode kleiner ist als im zweiten Zustand, wobei die bewegliche Elektrode im Wesentlichen parallel zu der festen Elektrode aufgehängt und durch mindestens einen freitragenden Arm mit einer Federkonstanten an einer Stützstruktur verankert ist, wobei das MEMS-Element mit einer Betätigungselektrode mit einem Betätigungsbereich für die Bereitstellung der Schließ- und Öffnungsspannung ausgestattet ist.

7. Bauelement nach Anspruch 1, wobei ein erstes und ein zweites MEMS-Element in dem Array verschiedene charakteristische Hysteresekurven **dadurch** aufweisen, dass Betätigungsbereiche der Steuerelektroden des ersten und zweiten MEMS-Elements verschieden sind und/oder die Federkonstanten der freitragenden Arme verschieden sind.

8. Bauelement nach Anspruch 6, wobei
- mindestens eine Dielektrikumsschicht mit einer dielektrischen Permitivität zwischen der festen und der beweglichen Elektrode vorliegt, so dass das MEMS-Element ein MEMS-Kondensator ist, von welchem Kondensator der erste Zustand eine erste Zustandskapazität aufweist, und
- ein erster und ein zweiter MEMS-Kondensator in dem Array verschiedene charakteristische Hysteresekurven **dadurch** aufweisen, dass die ersten Zustandskapazitäten des ersten und des zweiten MEMS-Kondensators verschieden sind.

9. Bauelement nach Anspruch 1, wobei die charakteristischen Hysteresekurven der MEMS-Elemente um eine gemeinsame Mittellinie in dem Arbeitsdiagramm herum zentriert sind.

10. Verfahren zum Ansteuern eines Arrays von MEMS-Elementen gemäß einem der vorhergehenden Ansprüche, wobei eine einzelne Steuerspannung gemeinsam an die MEMS-Elemente in dem Array angelegt wird, wobei die Spannung variiert wird, um die verschiedenen Zustände des Arrays zu erhalten.

## Revendications

1. Dispositif électronique comprenant une batterie d'éléments d'un système micro-électromécanique (MEMS), ladite batterie délivrant plusieurs états à sa sortie,
- les éléments MEMS présentant tous un premier et un deuxième état,
- une transition du premier au deuxième état étant réalisée par une tension d'ouverture et une transition du deuxième au premier état réalisée par une tension de fermeture, la batterie comprenant une entrée pour une unique tension de commande appliquée sur tous les éléments MEMS, les différents états de la batterie pouvant être obtenus en modifiant l'unique tension de commande,
- les éléments MEMS présentant tous une courbe caractéristique d'hystérèse de telle sorte que la tension d'ouverture est différente de la tension de fermeture, lesdites courbes caractéristiques d'hystérèse et les tensions correspondantes d'ouverture et de fermeture différant d'un élément MEMS à un autre élément MEMS,
**caractérisé en ce que**
- les courbes caractéristiques d'hystérèse diffèrent d'un élément MEMS à un autre élément MEMS par leur largeur individuelle et sont conçues de telle sorte que la courbe d'hystérèse dont la largeur est la plus étroite est située entièrement à l'intérieur de la largeur de la courbe d'hystérèse qui présente la largeur immédiatement supérieure.

2. Dispositif selon la revendication 1, dans lequel les éléments MEMS de la batterie sont raccordés en parallèle.

3. Dispositif selon la revendication 1, dans lequel le nombre d'éléments MEMS de la batterie est compris dans la plage de 2 à 10.

4. Dispositif selon la revendication 1, dans lequel l'entrée d'une unique tension de commande est un transistor.

5. Dispositif selon la revendication 1, qui comprend plusieurs batteries d'éléments MEMS, chaque batterie présentant une entrée prévue pour une unique tension de commande .

6. Dispositif selon la revendication 1, dans lequel chacun des éléments MEMS de la batterie présente une électrode fixe et une électrode mobile qui peut être approchée et écartée de l'électrode fixe par application respectivement de la tension de fermeture et de la tension d'ouverture de telle sorte que dans le premier état, la distance entre l'électrode fixe et l'électrode mobile est inférieure à celle qui prévaut dans le deuxième état, l'électrode mobile étant suspendue essentiellement en parallèle à l'électrode fixe et ancrée sur une structure de support par au moins un bras en porte-à-faux qui présente une constante élastique, l'élément MEMS étant doté d'une électrode d'actionnement qui présente une zone d'actionnement qui permet d'appliquer la tension de fermeture et la tension d'ouverture.

7. Dispositif selon la revendication 1, dans lequel un premier et un deuxième élément MEMS de la batterie ont des courbes caractéristiques d'hystérèse différentes par le fait que les zones d'actionnement des électrodes de commande du premier et du deuxième élément MEMS sont différentes et/ou que les constantes élastiques des bras en porte-à-faux sont différentes.

8. Dispositif selon la revendication 6, dans lequel
- au moins une couche diélectrique qui présente une constante diélectrique est prévue entre l'électrode fixe et l'électrode mobile de telle sorte que l'élément MEMS est un condensateur MEMS, le premier état de ce condensateur présentant une première capacité d'état, et
- un premier et un deuxième condensateur MEMS de la batterie ont des courbes caractéristiques d'hystérèse différentes par le fait que les capacités du premier état du premier et du deuxième condensateur MEMS sont différentes.

9. Dispositif selon la revendication 1, dans lequel les courbes caractéristiques d'hystérèse des éléments MEMS sont centrées autour d'une ligne centrale commune dans le diagramme de fonctionnement.

10. Procédé de pilotage d'une batterie d'éléments d'un système micro-électromécanique (MEMS) selon l'une quelconque des revendications précédentes, dans lequel une unique tension de commande est appliquée en commun sur les éléments MEMS de la batterie, la tension étant modifiée pour obtenir les différents états de la batterie.
